# EUROPEAN PATENT SPECIFICATION

(11) **EP 3 543 306 B1**
(45) Date of publication and mention of the grant of the patent: **10.09.2025**
(21) Application number: 17872786.3
(22) Date of filing: 09.11.2017
(51) Int. Cl.: C09J 7/22, B32B 27/00, B32B 27/18, C09J 201/00, H01B 1/00, H01B 1/22, H01L 21/301, H01L 21/683

(54) **JOINING FILM, TAPE FOR WAFER PROCESSING, METHOD FOR PRODUCING JOINED BODY, AND JOINED BODY**
FÜGEFILM, BAND ZUR WAFERVERARBEITUNG, VERFAHREN ZUR HERSTELLUNG EINES ZUSAMMENGEFÜGTEN GEGENSTANDES UND ZUSAMMENGEFÜGTER GEGENSTAND
FILM DE LIAISON, BANDE POUR TRAITEMENT DE TRANCHE, PROCÉDÉ DE PRODUCTION D'OBJET LIÉ, ET OBJET LIÉ

(30) Priority: 18.11.2016 JP 2016224996
(43) Date of publication of application: 25.09.2019
(73) Proprietor: Furukawa Electric Co., Ltd., Tokyo 100-8322 (JP)
(72) Inventor: NITTA, Norzafriza, Tokyo 100-8322 (JP); SATO, Yoshihiro, Tokyo 100-8322 (JP); FUJIWARA, Hidemichi, Tokyo 100-8322 (JP)
(74) Representative: advotec.
(86) International application number: PCT/JP2017/040384
(87) International publication number: WO 2018/092671

(56) References cited:
- EP-A1- 2 549 488
- EP-A1- 3 216 837
- EP-A1- 3 358 607
- EP-A1- 3 509 093
- EP-A1- 3 561 010
- WO-A1-2011/114751
- WO-A1-2013/094983
- WO-A1-2016/167245
- WO-A1-2017/057428
- JP-A- 2012 023 025
- JP-A- 2015 011 899
- JP-A- 2015 012 187

## Description

### TECHNICAL FIELD

The present invention relates to a joining film and a tape for wafer processing, and more particularly, the invention relates to a connecting film for connecting a semiconductor element with a substrate such as a circuit board or a ceramic substrate, and a tape for wafer processing including this connecting film.

### BACKGROUND ART

Conventionally, film-like adhesives (die-attach films) have been used for the adhesion between semiconductor chips and wiring boards and the like. Furthermore, a dicing-die bonding tape that combines two functions provided by a dicing tape for fixing a semiconductor wafer at the time of cutting and separating (dicing) a semiconductor wafer into individual chips and a die-attach film (also referred to as die bonding film) for adhering a cut-out semiconductor chip to a wiring board or the like, has been developed (see, for example, Patent Document 1).

In a case in which such a dicing-die bonding tape is used for the connection between a semiconductor element that performs control, supply, or the like of electric power (so-called power semiconductor element) and a substrate such as a circuit board, a ceramic substrate, or a lead frame, there is a problem that connection heat resistance is not sufficient.

Thus, for the connection between a power semiconductor element and a substrate, solder is generally used. Regarding such solder, cream solder obtained by adding a flux to a powder of solder and adjusting the viscosity to an appropriate level is mainly used. However, when a flux is used, there is a possibility that the surface of semiconductor elements may be contaminated, and there is a problem that a cleaning process is needed. Furthermore, in recent years, in view of environmental consideration, it is required to use lead-free solder materials that do not include lead. As lead-free solder materials that can cope with heat generation of power semiconductors, Au-Sn-based solders are available; however, since the Au-Sn-based solders are highly expensive, they are not practically useful. As solder materials that are cheaper than the Au-Sn-based solders, Sn-Ag-Cu-based solders are available; however, there is a problem that growth of intermetallic compounds caused by thermal history leads to lowering of reliability.

As a joining member that does not use solder, an anisotropic conductive film (ACF) obtained by molding a mixture of fine metal particles having electrical conductivity with a thermosetting resin into a film form, is available. However, since ACF includes a resin at a proportion larger than or equal to a certain level in order to obtain a satisfactory adhesion state, the contact between metal particles becomes point contact so that sufficient heat conduction cannot be expected, and there is a problem that connection heat resistance is not sufficient. Furthermore, regarding ACF, since there is a concern about deterioration of a thermosetting resin caused by high-temperature heating, ACF is not suitable for the connection of a power semiconductor having a large calorific value.

Furthermore, as another joining member that does not use solder, recently, a paste containing metal fine particles (hereinafter, referred to as metal paste) is available (see, for example, Patent Document 2). A metal paste is a product obtained by adding an organic dispersant that prevents condensation of metal fine particles at the time of storage or during a production process, and a dispersion aid substance that reacts with an organic dispersant at the time of joining and thereby eliminates the organic dispersant, to metal fine particles, and mixing this mixture with a solvent or the like into a paste form. The metal fine particles include very fine particles having at least a particle size of about 1 nm to 500 nm, and the surface is in an activated state.

When a semiconductor element and a substrate are to be joined using a metal paste, the metal paste is applied on the joining surface of the semiconductor element and/or the substrate by means of a dispenser or screen printing, and the metal paste is heated at 150°C to 300°C for a predetermined time (about 1 minute to 1 hour). Thereby, the organic dispersant reacts with the dispersion aid material, and the organic dispersant is eliminated. At the same time, the solvent is also volatilized and thereby eliminated. When the organic dispersant or the solvent is eliminated, the metal fine particles that are in an activated state bind to one another, and a simple substance film of the metal component is formed.

In a case in which a metal paste is applied on a joining surface using a dispenser or screen printing, it is necessary to regulate the amount of the solvent or the like and to lower the viscosity of the metal paste to a certain extent. However, when the viscosity is decreased, there is a problem that the metal paste is scattered at the time of applying the metal paste on a joining surface and adheres to parts other than the joining surface of the semiconductor element or the substrate, and the semiconductor element or the substrate is contaminated.

Thus, a connecting sheet obtained by forming a metal paste into a sheet form in advance has been suggested (see Patent Document 3).

### CITATION LIST

### PATENT DOCUMENT

Patent Document 1: JP 2010-265453 A
Patent Document 2: JP 2006-352080 A
Patent Document 3: JP 2013-236090 A
Patent Document 4: JP 2012 023025 A1
Patent Document 5: WO 2016/167245 A1

### SUMMARY OF THE INVENTION

### PROBLEM TO BE SOLVED BY THE INVENTION

However, in a case in which a semiconductor element and a substrate are joined using a connecting sheet having a joining layer obtained by forming a metal paste such as that described in Patent Document 3 into a sheet form in advance, since the joining layer itself does not have tacky adhesiveness, it is necessary to have the joining layer placed on the substrate using a suction tool or the like, have the semiconductor element placed thereon, and sinter the joining layer. Therefore, there is a problem that the process becomes complicated.

Thus, it is an object of the present invention to provide a joining film having sufficient connection heat resistance and high reliability, for which the joining process for joining a semiconductor element and a substrate is simple and easy, and a tape for wafer processing.

### MEANS FOR SOLVING PROBLEM

In order to solve the problems described above, a joining film according to the present invention is a joining film for joining a semiconductor element and a substrate, as defined in claim 1 The joining film having an electroconductive joining layer formed by molding an electroconductive paste containing metal fine particles (P) into a film form; and a tack layer having tackiness and being laminated with the electroconductive joining layer.

In order to solve the problems described above, the joining film according to the present invention is a joining film for joining a semiconductor element and a substrate, the joining film having an electroconductive joining layer formed by molding an electroconductive paste containing metal fine particles (P) into a film form; and a tack layer having tackiness and being laminated with the electroconductive joining layer, wherein the tack layer is thermally decomposed by heating at the time of joining, thus the metal fine particles (P) in the electroconductive joining layer are sintered, and thereby the semiconductor element and the substrate are joined.

Furthermore, with regard to the joining film, the average primary particle size of the metal fine particles is 10 to 500 nm, and the electroconductive paste includes an organic solvent (S).

Furthermore, with regard to the joining film, it is preferable that the metal fine particles (P) are formed from copper or silver.

Furthermore, with regard to the joining film, it is preferable that the electroconductive paste includes an organic binder (R).

Furthermore, with regard to the joining film, it is preferable that the tack layer is formed from one kind or two or more kinds selected from polyglycerin, and a a polyglycerin fatty acid ester,

Furthermore, with regard to the joining film, it is preferable that the organic solvent (S) includes an organic solvent (SC) formed from an alcohol and/or a polyhydric alcohol, each having a boiling point at normal pressure of 100°C or higher and having one or two or more hydroxyl groups in the molecule.

Furthermore, with regard to the joining film, it is preferable that the organic binder (R) is one kind or two or more kinds selected from a cellulose resin-based binder, an acetate resin-based binder, an acrylic resin-based binder, a urethane resin-based binder, a polyvinylpyrrolidone resin-based binder, a polyamide resin-based binder, a butyral resin-based binder, and a terpene-based binder.

Furthermore, in order to solve the problems described above, a tape for semiconductor processing according to the present invention has a self-adhesive film having a base material film and a self-adhesive layer provided on the base material film; and the above-mentioned joining film, the tape for semiconductor processing having the electroconductive joining layer of the joining film provided on the self-adhesive layer.

Furthermore, in order to solve the problems described above, a method for producing a joined body according to the present invention has a joining step of disposing a joining film having an electroconductive joining layer formed by molding an electroconductive paste containing metal fine particles (P) into a film form; and a tack layer having tackiness and being laminated with the electroconductive joining layer, between a semiconductor element and a substrate, subsequently heating the assembly, thermally decomposing the tack layer, thereby sintering the metal fine particles (P) of the electroconductive joining layer, and thereby joining the semiconductor element and the substrate.

Furthermore, in order to solve the problems described above, a joined body of a semiconductor and a substrate according to the present invention is a joined body of a semiconductor and a substrate, the joined body having, on a substrate, an electrically conductive connection member formed from a metal porous body and having a semiconductor element thereon, wherein the metal porous body has a porosity of 6% to 9% and an average pore diameter of 15 to 120 nm.

### EFFECT OF THE INVENTION

According to the present invention, a joining film having sufficient connection heat resistance and high reliability, for which the joining process for joining a semiconductor element and a substrate is simple and easy, a tape for wafer processing, a method for producing a joined body, and a joined body can be provided.

### BRIEF DESCRIPTION OF DRAWINGS

Fig. 1 is a cross-sectional view schematically illustrating a tape for wafer processing according to an embodiment of the present invention.
Fig. 2 is a diagram illustrating a semiconductor wafer bonded onto a tape for wafer processing.
Fig. 3 is a diagram for describing a dicing process.
Fig. 4 is a diagram for describing an expansion process.
Fig. 5 is a diagram for describing a pick-up process.
Fig. 6 is a cross-sectional diagram schematically illustrating a semiconductor device produced using the tape for wafer processing according to an embodiment of the present invention.

### MODE(S) FOR CARRYING OUT THE INVENTION

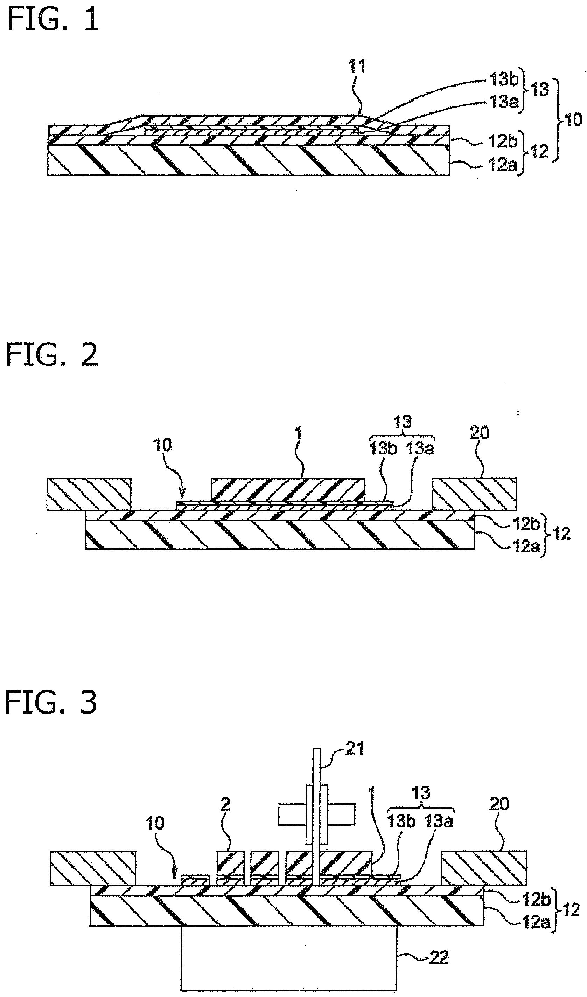

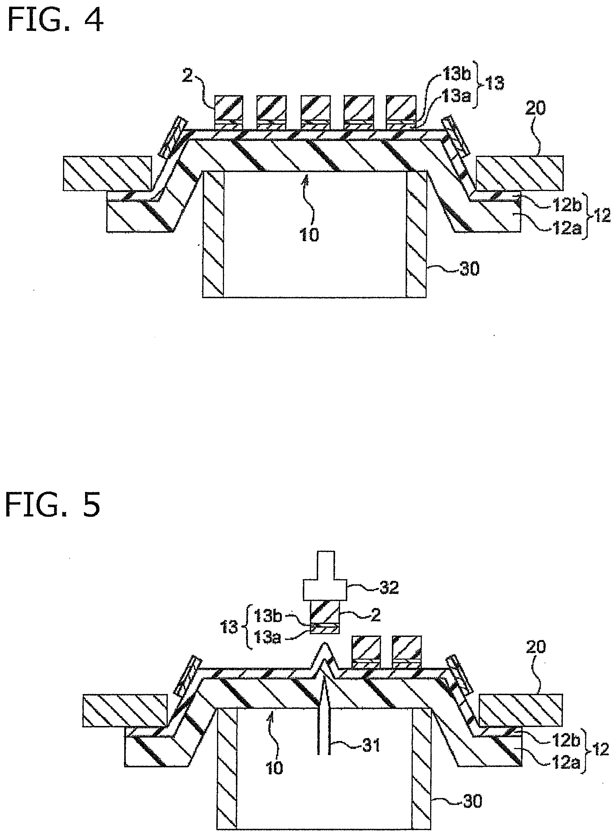

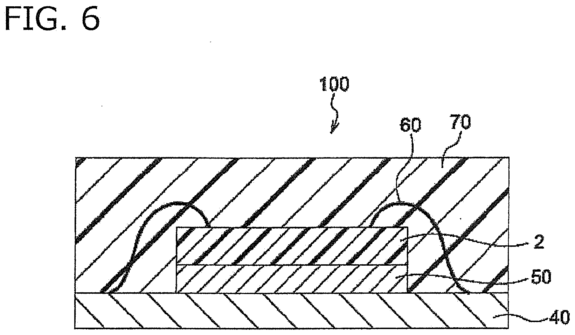

In the following description, the adhesive film and the tape for wafer processing according to embodiments of the present invention will be described based on the drawings. The tape for wafer processing according to an embodiment of the present invention will be described based on Figs. 1 to 5. Fig. 1 is a cross-sectional diagram illustrating a tape for wafer processing 10 according to an embodiment. Fig. 2 is a diagram illustrating a state in which a semiconductor wafer 1 is bonded onto the tape for wafer processing 10. Furthermore, Fig. 3 is a diagram for describing a dicing process in a production process for a semiconductor device, Fig. 4 is a diagram for describing an expansion process, and Fig. 5 is a diagram for describing a pick-up process. Fig. 6 is a cross-sectional diagram schematically illustrating a semiconductor device produced using the tape for wafer processing according to an embodiment of the present invention.

As illustrated in Fig. 1, the tape for wafer processing 10 according to an embodiment of the present invention has a self-adhesive film 12 composed of a base material film 12a and a self-adhesive layer 12b formed thereon; and a joining film 13 laminated with this self-adhesive film 12. The joining film 13 has an electroconductive joining layer 13a formed by molding an electroconductive paste containing metal fine particles (P) into a film form; and a tack layer 13b having tackiness and being laminated with the electroconductive joining layer 13a, with the electroconductive joining layer 13a being provided on the self-adhesive layer 12b. The tape for wafer processing 10 is used in both processes of a dicing process of cutting a semiconductor wafer 1 into semiconductor elements 2 (also referred to as chips or semiconductor chips), and a die-bonding process of joining the semiconductor elements 2 thus cut with a substrate 40 such as a circuit board, a ceramic substrate, or a lead frame (see Fig. 6). The dicing process will be described below with reference to Fig. 3.

The self-adhesive layer 12b may be configured to have one layer of self-adhesive layer, or may be configured to include two or more layers of self-adhesive layer laminated together. Meanwhile, in Fig. 1, a configuration in which a release film 11 is provided on the tape for wafer processing 10 in order to protect the joining film 13. As the release film 11, any known release film can be used.

The self-adhesive film 12 and the joining film 13 may be formed in advance into a predetermined shape according to the process or apparatus to be used.

In the following description, various constituent elements of the tape for wafer processing 10 of the present embodiment will be described in detail.

### (Joining film)

The joining film 13 is a material that is bonded together with the semiconductor wafer 1 and diced, is subsequently peeled from the self-adhesive film 12 when the individualized semiconductor elements 2 are picked up, is attached to a semiconductor element 2 and picked up, and is used as a joining material at the time of fixing the semiconductor element 2 to a substrate 40. Therefore, the joining film 13 is a material having self-adhesiveness and detachability, by which the joining film 13 can be peeled from the self-adhesive film 12 in a state of being attached to an individualized semiconductor element 2 in a pick-up process, and having sufficient joining reliability after joining the semiconductor element 2 and the substrate 40. The pick-up process will be described below with reference to Fig. 5.

The joining film 13 has an electroconductive joining layer 13a formed by molding an electroconductive paste containing metal fine particles (P) into a film form; and a tack layer 13b having tackiness and being laminated with the electroconductive joining layer 13a.

Meanwhile, the term tackiness as used for the present invention means adhesiveness, and specifically, the term means adhesiveness capable of retaining the electroconductive joining layer 13a on the semiconductor wafer 1 or a semiconductor element 2.

### [Electroconductive joining layer]

It is preferable that the electroconductive paste includes metal fine particles (P) and also includes an organic dispersing medium (D).

Regarding the metal fine particles (P) included in the electroconductive paste, fine particles of one kind selected from a metal element group consisting of copper, magnesium, aluminum, zinc, gallium, indium, tin, antimony, lead, bismuth, titanium, manganese, germanium, silver, gold, nickel, platinum, and palladium; fine particles of a mixture of two or more kinds selected from the above-described metal element group; fine particles formed from an alloy of two or more kinds elements selected from the above-described metal element group; fine particles of a mixture of fine particles of one kind selected from the above-described metal element group or fine particles of a mixture of two or more kinds selected from the above-described metal element group and fine particles formed from an alloy of two or more kinds of elements selected from the metal element group; oxides of these, hydroxides of these, or the like can be used.

Regarding the metal fine particles (P), when electrical conductivity and sinterability at the time of a heating treatment are considered, it is preferable to use (i) copper fine particles (P1) or (ii) metal fine particles comprising 90% to 100% by mass of copper fine particles (P1) and 10% to 0% by mass of one kind or two or more kinds of second metal fine particles (P2) selected from magnesium, aluminum, zinc, gallium, indium, tin, antimony, lead, bismuth, titanium, manganese, and germanium. The copper fine particles (P1) are formed from a metal having relatively high electrical conductivity, and the metal fine particles (P2) are formed from a metal having a relatively low melting point. In a case in which the copper fine particles (P1) in combination with the second metal fine particles (P2), it is preferable that the metal fine particles (P2) form an alloy with copper fine particles (P1) in the metal fine particles (P), or the metal fine particles (P2) form a coating layer at the surface of the copper fine particles (P1) in the meta fine particles (P). By using the copper fine particles (P1) and the metal fine particles (P2) in combination, the heating treatment temperature can be lowered, and the binding between metal fine particles can be achieved more easily.

The metal fine particles (P) have an average primary particle size before a heating treatment of 10 to 500 nm. When the average particle size of the metal fine particles (P) is less than 10 nm, there is a risk that it may be difficult to form a homogeneous particle size and pores over the entire sintered body by a heating treatment (sintering), and there are occasions in which the thermal cycle characteristics are deteriorated, while the joining strength are decreased. On the other hand, when the average particle size is more than 500 nm, the diameters of the metal fine particles and pores constituting the sintered body are close to a size in the order of micrometers, and thus, the thermal cycle characteristics are deteriorated. Regarding the average particle size of the metal fine particles (P) before the heating treatment, the diameter can be measured by scanning electron microscopy (SEM). For example, in a case in which the two-dimensional shape is an approximately circular shape, the diameter of the circle is measured; in a case in which the two-dimensional shape is an approximately elliptical shape, the minor axis of the ellipse is measured; in a case in which the two-dimensional shape is an approximately square shape, the length of an edge of the square is measured; and in a case in which the two-dimensional shape is an approximately rectangular shape, the length of a shorter edge of the rectangle is measured. The "average particle size" can be determined by measuring the particle sizes of a plurality of particles randomly selected in a number of 10 to 20 particles by observing with the above-mentioned microscope, and calculating the average value of the particle sizes.

The method for producing the metal fine particles (P) is not particularly limited, and for example, methods such as a wet chemical reduction method, an atomization method, a plating method, a plasma CVD method, and a MOCVD method can be used.

Regarding a method for producing metal fine particles (P) having an average primary particle size of 10 to 500 nm, specifically the method disclosed in JP 2008-231564 A can be employed. When the production method disclosed in this publication is employed, it is possible to obtain metal fine particles (P) having an average primary particle size of 10 to 500 nm easily. Furthermore, according to the method for producing metal fine particles disclosed in this publication, the electroconductive paste of the present invention can be produced by adding a flocculant to a reduction reaction aqueous solution after completion of a reduction reaction of metal ions, subsequently collecting metal fine particles by centrifugation or the like, from which the impurities in the reaction liquid have been eliminated, adding an organic dispersant (D) to the metal fine particles, and kneading the mixture.

In order to disperse the metal fine particles (P) uniformly in the electroconductive paste, it is important to select a particular organic dispersing medium (D) having excellent dispersibility, sinterability at the time of a heating treatment, and the like. The organic dispersing medium (D) can disperse the metal fine particles (P) in the electroconductive paste and regulate the viscosity of the electroconductive paste, can thereby maintain a film shape, and can exhibit the function as a reducing agent in a liquid form or a gaseous form at the time of a heating treatment. It is preferable that the organic dispersing medium (D) includes at least an organic solvent (S) and further includes an organic binder (R).

It is preferable that the organic solvent (S) includes an organic solvent (SC) formed from an alcohol and/or a polyhydric alcohol, each having a boiling point at normal pressure of 100°C or higher and having one or two or more hydroxyl groups in the molecule. Furthermore, it is preferable that the organic solvent (S) is one selected from (i) an organic solvent (S1) including at least 5% to 90% by volume of an organic solvent (SA) having an amide group, 5% to 45% by volume of a low-boiling point organic solvent (SB) having a boiling point at normal pressure of 20°C to 100°C, and 5% to 90% by volume of an organic solvent (SC) formed from an alcohol and/or a polyhydric alcohol, each having a boiling point at normal pressure of 100°C or higher and having one or two or more hydroxyl groups in the molecule; and (ii) an organic solvent (S2) including at least 5% to 95% by volume of an organic solvent (SA) having an amide group, and 5% to 95% by volume of an organic solvent (SC) formed from an alcohol and/or a polyhydric alcohol, each having a boiling point at normal pressure of 100°C or higher and having one or two or more hydroxyl groups in the molecule.

In a case in which another organic solvent component other than those described above is incorporated, a polar organic solvent such as tetrahydrofuran, diglyme, ethylene carbonate, propylene carbonate, sulfolane, or dimethyl sulfoxide can be used.

The organic solvent (S1) is an organic solvent including at least 5% to 90% by volume of an organic solvent (SA) having an amide group, 5% to 45% by volume of a low-boiling point organic solvent (SB) having a boiling point at normal pressure of 20°C to 100°C, and 5% to 90% by volume of an organic solvent (SC) formed from an alcohol and/or a polyhydric alcohol, each having a boiling point at normal pressure of 100°C or higher and having one or two or more hydroxyl groups in the molecule. The organic solvent (SA) is included in the organic solvent (S1) at a proportion of 5% to 90% by volume and has an action of enhancing dispersibility and storage stability in the electroconductive paste and enhancing adhesiveness at the joining surface when a sintered body is formed by heat-treating the electroconductive joining layer on the joining surface. The organic solvent (SB) is included in the organic solvent (S1) at a proportion of 5% to 45% by volume or more and has an action of lowering the interaction between solvent molecules in the electroconductive paste and enhancing the affinity of the dispersed metal fine particles (P) for the organic solvent (S1) . The organic solvent (SC) is included in the organic solvent (S1) at a proportion of 5% to 90% by volume or more and makes it possible to promote dispersibility in the electroconductive paste as well as further long-term stabilization of the dispersibility. Furthermore, when the organic solvent (SC) is incorporated into a mixed organic solvent, as the electroconductive joining layer is disposed on the joining surface and heat-treated, uniformity of the sintered body is enhanced. Furthermore, the effect of promoting reduction of the oxide film carried by the organic solvent (SC) also works, and a highly electroconductive joining member can be obtained. The phrase "the organic solvent (S1) is an organic solvent including at least 5% to 90% by volume of the organic solvent (SA), 5% to 45% by volume of the organic solvent (SB), and 5% to 90% by volume of the organic solvent (SC)" means that the organic solvent (S1) may be a mixture of the organic solvent (SA), organic solvent (SB), and organic solvent (SC) so as to achieve 100% by volume as the above-mentioned mixing proportion, and may have other organic solvent components mixed in within the range of the mixing proportion, to the extent that does not impair the effect of the present invention. However, in this case, it is preferable that a component composed of the organic solvent (SA), organic solvent (SB), and organic solvent (SC) is included at a proportion of 90% by volume or more, and more preferably 95% by volume or more.

The organic solvent (S2) is an organic solvent including at least 5% to 95% by volume of an organic solvent (SA) having an amide group, and 5% to 95% by volume of an organic solvent (SC) formed from an alcohol and/or a polyhydric alcohol, each having a boiling point at normal pressure of 100°C or higher and having one or two or more hydroxyl groups in the molecule. The organic solvent (SA) is included in the organic solvent (S2) at a proportion of 5% to 95% by volume and has an action of enhancing the dispersibility and storage stability in the mixed organic solvent and enhancing the adhesiveness at the joining surface when a metal porous body is formed by heat-treating the electroconductive paste. The organic solvent (SC) is included in the organic solvent (S2) at a proportion of 5% to 95% by volume and further enhances dispersibility in the electroconductive paste. Furthermore, when the organic solvent (SA) and organic solvent (SC) are incorporated into the organic solvent (S2), as the electroconductive joining layer is disposed on the joining face and then heat-treated, sintering can be carried out even at a relatively low heating treatment temperature. The phrase "the organic solvent (S2) is an organic solvent including at least 5% to 95% by volume of an organic solvent (SA) and 5% to 95% by volume of an organic solvent (SC)" means that the organic solvent (S2) may be a mixture of the organic solvent (SA) and the organic solvent (SC) so as to achieve 100% by volume as the above-mentioned mixing proportion, and may have other organic solvent components mixed in within the range of the mixing proportion, to the extent that does not impair the effect of the present invention. However, in this case, it is preferable that a component composed of the organic solvent (SA) and the organic solvent (SC) is included at a proportion of 90% by volume or more, and more preferably 95% by volume or more.

In the following description, specific examples of the organic solvent (SC), organic solvent (SA), and organic solvent (SB) described above will be illustrated.

The organic solvent (SC) is an organic compound that comprises an alcohol and/or a polyhydric alcohol, each having a boiling point at normal pressure of 100°C or higher and having one or two or more hydroxyl groups in the molecule, and has reducing properties. Furthermore, an alcohol having 5 or more carbon atoms and a polyhydric alcohol having 2 or more carbon atoms are preferred, and an alcohol or polyhydric alcohol that is liquid at normal temperature and has high relative permittivity, for example, a relative permittivity of 10 or higher, is preferred. Since metal fine particles (P) having an average primary particle size of 10 to 500 nm have a large surface area of the fine particles, it is necessary to consider the influence of oxidation. However, since the organic solvent (SC) to be listed below exhibits a function as a reducing agent in a liquid form and a gas form at the time of a heating treatment (sintering), the organic solvent (SC) suppresses oxidation of the metal fine particles (P) at the time of a heating treatment and promotes sintering. Specific examples of the organic solvent (SC) include ethylene glycol, diethylene glycol, 1,2-propanediol, 1,3-propanediol, 1,2-butanediol, 1,3-butanediol, 1,4-butanediol, 2-butene-1,4-diol, 2,3-butanediol, pentanediol, hexanediol, octanediol, glycerol, 1,1,1-trishydroxymethylethane, 2-ethyl-2-hydroxymethyl-1,3-propanediol, 1,2,6-hexanetriol, 1,2,3-hexanetriol, and 1,2,4-butanetriol.

Furthermore, as specific examples of the organic solvent (SC), sugar alcohols such as threitol (D-threitol), erythritol, pentaerythritol, pentitol, and hexitol can be used, and examples of pentitol includes xylitol, ribitol, and arabitol. Examples of the hexitol include mannitol, sorbitol, and dulcitol. Furthermore, sugars such as glyceric aldehyde, dioxyacetone, threose, erythrulose, erythrose, arabinose, ribose, ribulose, xylose, xylulose, lyxose, glucose, fructose, mannose, idose, sorbose, gulose, talose, tagatose, galactose, allose, altrose, lactose, isomaltose, gluco-heptose, heptose, maltotriose, lactulose, and trehalose can also be used. However, for those compounds having high melting points, they can be used as mixtures with other organic solvents (SC) having low melting points. Among the alcohols described above, a polyhydric alcohol having two or more hydroxyl groups in the molecule is more preferred, and ethylene glycol and glycerol are particularly preferred.

The organic solvent (SA) is a compound having an amide group (-CONH-), and particularly, a compound having high relative permittivity is preferred. Examples of the organic solvent (A) include N-methylacetamide (191.3 at 32°C), N-methylformamide (182.4 at 20°C), N-methylpropanamide (172.2 at 25°C), formamide (111.0 at 20°C), N,N-dimethylacetamide (37.78 at 25°C), 1,3-dimethyl-2-imidazolidinone (37.6 at 25°C), N,N-dimethylformamide (36.7 at 25°C), 1-methyl-2-pyrrolidone (32.58 at 25°C), hexamethylphosphoric triamide (29.0 at 20°C), 2-pyrrolidinone, ε-caprolactam, and acetamide; however, these can also be used as mixtures. Meanwhile, the numbers in the parentheses after the names of the above-described compounds having amide groups represent the relative permittivity at the measurement temperature of various solvents. Among these, N-methylacetamide, N-methylformamide, formamide, acetamide, and the like, all having a relative permittivity of 100 or higher, can be suitably used. In the case of a solid at normal temperature, such as N-methylacetamide (melting point: 26°C to 28°C), the solid can be mixed with another solvent and can be used in a liquid form at the treatment temperature.

The organic solvent (SB) is an organic compound having a boiling point at normal pressure in the range of 20°C to 100°C. When the boiling point at normal pressure is lower than 20°C, at the time of storing a particle dispersion liquid including the organic solvent (SB) at normal temperature, there is a risk that the component of the organic solvent (SB) is volatilized, and the paste composition may be changed. Furthermore, in a case in which the boiling point at normal pressure is 100°C or lower, it can be expected that an effect of decreasing the mutual attractive force between solvent molecules caused by addition of the solvent and further enhancing the dispersibility of fine particles is effectively exhibited. Examples of the organic solvent (SB) include an ether-based compound (SB1) represented by general formula: R¹-O-R² (wherein R¹ and R² each independently represent an alkyl group, and the number of carbon atoms is 1 to 4), an alcohol (SB2) represented by general formula: R³-OH (wherein R³ represents an alkyl group, and the number of carbon atoms is 1 to 4), a ketone-based compound (SB3) represented by general formula: R⁴-C(=O)-R⁵ (wherein R⁴ and R⁵ each independently represent an alkyl group, and the number of carbon atoms is 1 or 2), and an amine-based compound (SB4) represented by general formula: R⁶-(N-R⁷)-R⁸ (wherein R⁶, R⁷ and R⁸ each independently represent an alkyl group or a hydrogen atom, and the number of carbon atoms is 0 to 2).

Examples of the organic solvent (SB) will be listed below, and the numbers in the parentheses after the compound names represent boiling points at normal pressure. Examples of the ether-based compound (SB1) include diethyl ether (35°C), methyl propyl ether (31°C), dipropyl ether (89°C), diisopropyl ether (68°C), methyl-t-butyl ether (55.3°C), t-amyl methyl ether (85°C), divinyl ether (28.5°C), ethyl vinyl ether (36°C), and allyl ether (94°C). Examples of the alcohol (SB2) include methanol (64.7°C), ethanol (78.0°C), 1-propanol (97.15°C), 2-propanol (82.4°C), 2-butanol (100°C), and 2-methyl-2-propanol (83°C). Examples of the ketone-based compound (SB3) include acetone (56.5°C), methyl ethyl ketone (79.5°C), and diethyl ketone (100°C). Furthermore, examples of the amine-based compound (SB4) include triethylamine (89.7°C) and diethylamine (55.5°C).

The organic binder (R) exhibits the functions of suppressing aggregation of metal fine particles (P) in the electroconductive paste, regulating the viscosity of the electroconductive paste, and maintaining the shape of the electrically conductive connection member precursor. The organic binder (R) is preferably one kind or two or more kinds selected from a cellulose resin-based binder, an acetate resin-based binder, an acrylic resin-based binder, a urethane resin-based binder, a polyvinylpyrrolidone resin-based binder, a polyamide resin-based binder, a butyral resin-based binder, and a terpene-based binder. Specifically, it is preferable that the cellulose resin-based binder is one kind or two or more kinds selected from acetyl cellulose, methyl cellulose, ethyl cellulose, butyl cellulose, and nitrocellulose; the acetate resin-based binder is one kind or two or more kinds selected from methyl glycol acetate, ethyl glycol acetate, butyl glycol acetate, ethyl diglycol acetate, and butyl diglycol acetate; the acrylic resin-based binder is one kind or two or more kinds selected from methyl methacrylate, ethyl methacrylate, and butyl methacrylate; the urethane resin-based binder is one kind or two or more kinds selected from 2,4-tolylene diisocyanate and p-phenylene diisocyanate; the polyvinylpyrrolidone resin-based binder is one kind or two or more kinds selected from polyvinylpyrrolidone and N-vinylpyrrolidone; the polyamide resin-based binder is one kind or two or more kinds selected from polyamide 6, polyamide 66, and polyamide 11; the butyral resin-based binder is one kind or two or more kinds selected from polyvinyl butyral; and the terpene-based binder is one kind or two or more kinds selected from pinene, cineole, limonene, and terpineol.

The electroconductive paste is an electroconductive paste including metal fine particles (P) and an organic dispersing medium (D) comprising an organic solvent (S), or an electroconductive paste including the metal fine particles (P) and an organic dispersing medium (D) comprising an organic solvent (S) and an organic binder (R). When this is subjected to a heating treatment, the electroconductive paste functions as a joining material by utilizing the principle in which, as a certain temperature is reached, evaporation of the organic solvent (S) or evaporation of the organic solvent (S) and thermal decomposition of the organic binder (R) proceed, the surface of the metal fine particles (P) appears, and the metal fine particles bind with one another (sinter) at the surface. It is preferable that the mixing proportion (P/D) of the metal fine particles (P) and the organic dispersing medium (D) in the electroconductive paste is 50% to 85% by mass / 50% to 15% by mass (the sum of percent by mass is 100% by mass). To the extent that does not impair the effect of the present invention, metal fine particles, organic dispersing medium, and the like other than those described above can be incorporated into the electroconductive paste of the present invention.

When the mixing proportion of the metal fine particles (P) is more than 85% by mass, the paste becomes highly viscous, insufficient binding occurs between the surfaces of the metal fine particles (P) during the heating treatment, and there is a risk that electrical conductivity may deteriorate. On the other hand, when the mixing proportion of the metal fine particles (P) is less than 50% by mass, the viscosity of the paste is decreased, it is difficult to maintain the film shape, and there is a risk that defects such as shrinkage at the time of heating treatment may occur. Furthermore, there is also a risk that when a heating treatment is carried out, an inconvenience that the rate of evaporation of the organic dispersing medium (D) is slowed may come together. From such a viewpoint, it is more preferable that the mixing proportion (P/D) of the metal fine particles (P) and the organic dispersing medium (D) is 55% to 80% by mass / 45% to 20% by mass. Furthermore, it is preferable that the mixing proportion (S/R) of the organic solvent (S) and the organic binder (R) in the organic dispersing medium (D) is 80% to 100% by mass / 20% to 0% by mass (the sum of percentage by mass is altogether 100% by mass) .

When the mixing proportion of the organic binder (R) in the organic dispersing medium (D) is more than 20% by mass, at the time of heat-treating the electroconductive joining layer 13a, the rate at which the organic binder (R) is thermally decomposed and scattered is decreased. Furthermore, when the amount of residual carbon in the electroconductive connection member increases, sintering is inhibited, and there is a possibility that problems such as cracking and peeling may occur, which is not preferable. In a case in which through the selection of the organic solvent (S), the metal fine particles (P) can be uniformly dispersed only by the solvent, and functions of regulating the viscosity of the electroconductive paste and maintaining the film shape can be exhibited, a component comprising only the organic solvent (S) can be used as the organic dispersing medium (D). In the electroconductive paste, known additives such as a defoamant, a dispersant, a plasticizer, a surfactant, and a thickening agent can be added to the component described above, as necessary. At the time of producing the electroconductive paste, various components are mixed, and then the mixture can be kneaded using a ball mill or the like.

### [Tack layer]

The tack layer 13b is intended for retaining the electroconductive joining layer 13a on a semiconductor wafer 1 or a semiconductor element 2, and has tackiness. Furthermore, the tack layer 13b is thermally decomposed by the heating at the time of joining a semiconductor element 2 and a substrate 40. The tack layer 13b is not particularly limited as long as it has such properties, and the tack layer 13b may be formed from any material.

Since the electroconductive joining layer 13a lacks tackiness, the tack layer 13b is a layer for improving adhesiveness between a semiconductor wafer 1 or a semiconductor element 2 and the electroconductive joining layer 13a. If the tack layer 13b is not present, since the adhesive force between the semiconductor wafer 1 or the semiconductor element 2 and the electroconductive joining layer 13a is weak, detachment occurs between the semiconductor wafer 1 or the semiconductor element 2 and the electroconductive joining layer 13a at the time of dicing of the semiconductor wafer 1 or at the time of picking up the semiconductor element 2. Furthermore, the tack layer 13b is also a layer for increasing the adhesive force of the electroconductive joining layer 13a to the semiconductor wafer 1 or the semiconductor element 2. As the adhesive force increases, the joining strength at the time of joining the semiconductor element 2 and a substrate 40 by means of the electroconductive joining layer 13a is also increased.

According to the present invention, it is important that as the tack layer 13b is thermally decomposed by the heating at the time of joining a semiconductor element 2 and a substrate 40, the semiconductor element 2 and the substrate 40 are mechanically joined through the electroconductive joining layer 13a. Therefore, it is preferable for the tack layer 13b that the weight reduction in a thermogravimetric analysis in an air atmosphere at the heating temperature at the time of joining at a rate of temperature increase of 5°C/min is 70% by weight or more, more preferably 85% by weight or more, and even more preferably 95% by weight or more.

Furthermore, since the tack layer 13b is in direct contact with the semiconductor element 2 at the time of joining, an effect of activating the surface of the electrodes of the semiconductor element 2 is also expected. This is speculated to be because, when the substance included in the tack layer 13b is decomposed at the time of heating, the substance reacts with the oxidized layer of the electrode surface, which is formed from a metal, and cleans the metal surface. As the surface of the electrodes of the semiconductor element 2 is activated as such, the adhesive force between the electrodes of the semiconductor element 2 and the electroconductive joining layer 13a can be enhanced.

As the material that constitutes the tack layer 13b, it is preferable to use a material that does not dissolve in a polar or non-polar solvent at room temperature but dissolves easily when heated to the melting point. By heating such a material to the melting point, dissolving the material in a solvent, applying the solution on the electroconductive joining layer 13a or the like, subsequently cooling the solution to room temperature, and evaporating the solvent, a film-like body having tackiness can be formed. Regarding the solvent, any known solvent can be used as appropriate; however, it is preferable to use a low-boiling point solvent in order to facilitate evaporation at the time of film formation.

Furthermore, it is more preferable that the tack layer 13b is formed from a substance that reduces the metal fine particles (P) when the metal fine particles (P) in the electroconductive paste are heated and sintered. When a substance that causes the decomposition reaction of the tack layer 13b to occur in a multi-stage reaction, the reaction temperature range is broad, the metal fine particles (P) are reduced, and thereby the resistivity after sintering of the metal fine particles (P) is decreased. Thus, electrical conductivity is increased.

It is preferable that the tack layer 13b is formed from, for example, one kind or two or more kinds selected from polyglycerin; polyglycerin fatty acid ester such as diglycerin stearate (melting point: 61°C) or diglycerin laurate (melting point: 34 °C);

Furthermore, in the tack layer 13b, known additives such as a defoamant, a dispersant, a plasticizer, a surfactant, and a thickening agent can be added as necessary, to the extent that tackiness and thermal decomposability are not inhibited, and problems do not occur in view of contamination of the semiconductor element 2 or the substrate 40 or in view of bump gas generation.

Next, a method for producing the joining film 13 will be described. First, a release film is placed on a mounting stand, and a spacer is disposed on the release film. The spacer is, for example, a plate made of a metal such as SUS, and has a circular opening at the center. The above-described electroconductive paste is disposed on the release film at the opening of the spacer, screen printing is performed using a squeegee, and thus the electroconductive paste is uniformly rolled. Thereby, the electroconductive paste is turned into a circular film form. Subsequently, the release film and the spacer are removed. Then, the electroconductive paste that has been molded into a circular film form is preliminarily dried, and thereby, the electroconductive joining layer 13a is formed. The time for preliminary drying varies depending on the print thickness; however, for example, the time can be set to 5 to 20 minutes.

Subsequently, the material of the constituent component of the tack layer 13b described above is heated and kneaded in a solvent, and the resultant is applied on the electroconductive joining layer 13a using a squeegee method, a spray coating method, or the like and cooled. Subsequently, the coating is heated and dried to evaporate the solvent, and thus, the tack layer 13b is formed.

Meanwhile, in the present embodiment, the joining film 13 of the present invention is provided on the self-adhesive film 12 so that the entire assembly constitutes a tape for wafer processing 10. However, the joining film 13 as a simple material may be handled as the material for producing the tape for wafer processing 10, and in that case, it is preferable that the joining film 13 has the both surfaces protected by protective films. As the protective film, known films such as a polyethylene-based film, a polystyrene-based film, a polyethylene terephthalate (PET)-based film, and a release-treated film can be used; however, from the viewpoint of having the hardness suitable for retaining the joining film 13, it is preferable to use a polyethylene film or a polystyrene film. The thickness of the protective film is not particularly limited and may be set as appropriate; however, the thickness is preferably 10 to 300 µm.

### (Self-adhesive film)

The self-adhesive film 12 is a film having sufficient self-adhesive force so that, when a semiconductor wafer 1 is diced, the semiconductor wafer 1 retained on the joining film 13 is not detached, and having a low self-adhesive force enabling the self-adhesive film 12 to be easily detached from the joining film 13 when individualized semiconductor elements 2 are picked up after dicing. According to the present embodiment, regarding the self-adhesive film 12, as illustrated in Fig. 1, an example in which a self-adhesive layer 12b is provided on a base material film 12a has been mentioned; however, the self-adhesive film is not limited to this, and any known self-adhesive film that is used as a dicing tape can be used.

As the base material film 12a of the self-adhesive film 12, any conventionally known base material film can be used without particular limitations. However, as will be described below, in the present embodiment, since a radiation-curable material among energy-curable materials is used as the self-adhesive layer 12b, a base material film having radiation transmissibility is used.

Examples of the material for the base material film 12a include homopolymers or copolymers of α-olefins, such as polyethylene, polypropylene, an ethylene-propylene copolymer, polybutene-1, poly-4-methylpentene-1, an ethylene-vinyl acetate copolymer, an ethylene-ethyl acrylate copolymer, an ethylene-methyl acrylate copolymer, an ethylene-acrylic acid copolymer, and an ionomer, or mixtures of these; thermoplastic elastomers such as polyurethane, a styrene-ethylene-butene copolymer, a pentene-based copolymer, and a polyamide-polyol copolymer, and mixtures of these. Furthermore, the base material film 12a may be formed from a mixture of two or more kinds of materials selected from the groups of these, and the base material film 12a may be a single layer or multilayer of these materials. The thickness of the base material film 12a is not particularly limited and may be appropriately set; however, the thickness is preferably 50 to 200 µm.

In the present embodiment, the self-adhesive layer 12b is cured by irradiating the self-adhesive film 12 with radiation such as ultraviolet radiation, and the self-adhesive layer 12b is made easily detachable from the joining film 13. Therefore, regarding the resin for the self-adhesive layer 12b, it is preferable to produce a self-adhesive by mixing, as appropriate, a radiation-polymerizable compound with various known elastomers that are used in self-adhesives, such as a chlorinated polypropylene resin, an acrylic resin, a polyester resin, a polyurethane resin, an epoxy resin, an addition reaction-type organopolysiloxane-based resin, a silicon acrylate resin, an ethylene-vinyl acetate copolymer, an ethylene-ethyl acrylate copolymer, an ethylene-methyl acrylate copolymer, an ethylene-acrylic acid copolymer, polyisoprene, a styrene-butadiene copolymer, and hydrogenation products thereof, or mixtures thereof. Furthermore, various surfactants or surface smoothing agents may also be added thereto. The thickness of the self-adhesive layer 12b is not particularly limited and may be set as appropriate; however, the thickness is preferably 5 to 30 µm.

Regarding the radiation-polymerizable compound, for example, a low-molecular weight compound that can form a three-dimensional network by light irradiation in the molecule and has at least two or more photopolymerizable carbon-carbon double bonds, or a polymer or oligomer having a photopolymerizable carbon-carbon double bond group as a substituent is used. Specifically, trimethylolpropane triacrylate, pentaerythritol triacrylate, pentaerythritol tetraacrylate, dipentaerythritol monohydroxypentaacrylate, dipentaerythritol hexaacrylate, 1,4-butylene glycol diacrylate, 1,6-hexanediol diacrylate, polyethylene glycol diacrylate, oligo ester acrylate, silicon acrylate, and copolymers of acrylic acid or various acrylic acid esters are applicable.

Furthermore, in addition to the acrylate-based compounds such as described above, a urethane acrylate-based oligomer can also be used. A urethane acrylate-based oligomer is obtained by reacting a terminal isocyanate urethane prepolymer that is obtainable by reacting a polyester type or polyether type polyol compound with a polyvalent isocyanate compound (for example, 2,4-tolylene diisocyanate, 2,6-tolylene diisocyanate, 1,3-xylylene diisocyanate, 1,4-xylylene diisocyanate, or diphenylmethane 4,4-diisocyanate), with an acrylate or methacrylate having a hydroxyl group (for example, 2-hydroxyethyl acrylate, 2-hydroxyethyl methacrylate, 2-hydroxypropyl acrylate, 2-hydroxypropyl methacrylate, polyethylene glycol acrylate, or polyethylene glycol methacrylate). Meanwhile, the self-adhesive layer 12b may be formed from a mixture of two or more kinds selected from the above-mentioned resins.

Regarding the composition for the self-adhesive layer 12b, a composition obtained by mixing, as appropriate, an acrylic self-adhesive, a photopolymerization initiator, a curing agent, and the like, in addition to the radiation-polymerizable compound that is cured when irradiated with radiation, can also be used.

In the case of using a photopolymerization initiator, for example, isopropyl benzoin ether, isobutyl benzoin ether, benzophenone, Michler's ketone, chlorothioxanthone, dodecylthioxanthone, dimethylthioxanthone, diethylthioxanthone, benzyl dimethyl ketal, α-hydroxycyclohexyl phenyl ketone, or 2-hydroxymethylphenylpropane can be used. The amount of incorporation of these photopolymerization initiators is preferably 0.01 to 5 parts by mass with respect to 100 parts by mass of the acrylic copolymer.

The self-adhesive film 12 can be produced by a method that is conventionally known as a method for producing a dicing tape. The tape for wafer processing 10 can be produced by sticking the electroconductive joining layer 13a of the above-mentioned electroconductive joining layer 13 onto the self-adhesive layer 12b of the self-adhesive film 12.

### (Method of using tape for wafer processing)

During a production process for a semiconductor device 100 (see Fig. 6), the tape for wafer processing 10 is used as follows. In Fig. 2, a configuration in which a semiconductor wafer 1 and a ring frame 20 are bonded to a tape for wafer processing 10 is illustrated.

First, as illustrated in Fig. 2, the self-adhesive layer 12b of the self-adhesive film 12 is attached to a ring frame 20, and a semiconductor wafer 1 is bonded to the tack layer 13b of the joining film 13. There are no limitations in the order of attachment of these, and the self-adhesive layer 12b of the self-adhesive film 12 may be attached to the ring frame 20 after the semiconductor wafer 1 is bonded to the joining film 13. Furthermore, it is also acceptable that attaching of the self-adhesive film 12 to the ring frame 20 and bonding of the semiconductor wafer 1 to the joining film 13 are carried out simultaneously.

Then, as illustrated in Fig. 3, a dicing process of the semiconductor wafer 1 is carried out, and then a process of irradiating the self-adhesive film 12 with energy radiation, for example, ultraviolet radiation, is carried out. Specifically, first, in order to dice the semiconductor wafer 1 and the joining film 13 using a dicing blade 21, the tape for wafer processing 10 is supported by suction from the self-adhesive film 12 surface side, by means of a suction stage 22. Then, the semiconductor wafer 1 and the joining film 13 are individualized by cutting into semiconductor element 2 units using the dicing blade 21, and then the self-adhesive film 12 is irradiated with energy radiation from the lower surface side. The self-adhesive layer 12b is cured by this irradiation with energy radiation, and the self-adhesive force is decreased. Meanwhile, instead of irradiation with energy radiation, the self-adhesive force of the self-adhesive layer 12b of the self-adhesive film 12 may be decreased by means of an external stimulus such as heating. In a case in which the self-adhesive layer 12b is configured to have two or more layers of self-adhesive layers laminated together, one layer among the various self-adhesive layers, or all of the layers are cured by irradiation with energy radiation, and the self-adhesive force of one layer among the various self-adhesive layers, or all of the layers may be decreased.

Subsequently, as illustrated in Fig. 4, an expansion process of stretching the self-adhesive film 12 retaining the diced semiconductor elements 2 and joining film 13 in the circumferential direction of the ring frame 20, is carried out. Specifically, a push-up member 30 having a hollow cylindrical shape is raised up from the lower surface side of the self-adhesive film 12 against the self-adhesive film 12 in a state in which a plurality of semiconductor elements 2 and the joining film 13 that have been diced, and the self-adhesive film 12 is stretched in the circumferential direction of the ring frame 20.

After the expansion process is carried out, as illustrated in Fig. 5, a pick-up process of picking up the semiconductor element 2 is carried out in a state in which the self-adhesive film 12 has been stretched. Specifically, the semiconductor elements 2 are pushed up by a pin 31 from the lower surface side of the self-adhesive film 12, and also, the semiconductor elements 2 are suctioned with a suction tool 32 from the upper surface side of the self-adhesive film 12. Thereby, individualized semiconductor elements 2 are picked up together with the joining film 13.

Then, after the pick-up process is carried out, a joining process is carried out. Specifically, the electroconductive joining layer 13a side of the joining film 13 picked up together with the semiconductor element 2 in the pick-up process is disposed on the joining position of a substrate 40 such as a lead frame or a package substrate. Subsequently, the joining film 13 is heat-treated at a temperature of 150°C to 350°C. At this time, the tack layer 13b is thermally decomposed, and at the same time, the organic dispersing medium (D) in the electroconductive joining layer 13a is eliminated. Thus, the metal fine particles (P) aggregate at a temperature lower than the melting point of the metal in a bulk state due to the surface energy of the fine particles, and binding (sintering) proceeds between the metal fine particlesurfaces. Thus, an electrically conductive connection member 50 formed from a metal porous body is formed. When the organic solvent (SC) is included in the organic solvent (S) at the time of the heating treatment, this solvent exhibits a reducing function in a liquid form and a gaseous form, and therefore, oxidation of the metal fine particles (P) is suppressed. Thus, sintering is accelerated. Meanwhile, in a case in which an organic solvent (S) having a relatively low boiling point is included as the organic dispersing medium (D) in the electroconductive joining layer 13a, a drying process may be provided before the heating treatment, and at least a portion of the organic solvent (S) may be evaporated and eliminated in advance. Through such a heating treatment, the semiconductor element 2 and the substrate 40 are mechanically joined. Meanwhile, the joining process may be carried out without added pressure or under added pressure. In a case in which pressure is applied, the adhesiveness between the electroconductive paste and the lead frame, package substrate or the like is enhanced.

Since the electrically conductive connection member 50 is a metal porous body formed as the metal fine particles (P) are subjected to surface contact and are bound (sintered), the electrically conductive connection member 50 has appropriate elasticity and softness, while the electrical conductivity is not impaired. The porosity of the metal porous body is 6% to 9% by volume, and the average pore diameter is in the range of 15 to 120 nm. The methods for measuring the porosity, the average particle size of the metal fine particles, and the average pore diameter in the electrically conductive connection member 50 are as follows.

### (1) Method for measuring average particle size of metal fine particles

For metal fine particles, the cross-sections of randomly selected ten particles are observed by scanning electron microscopy (SEM), the diameter of the maximum inscribed circle for the two-dimensional shape of each of the cross-sections is measured, and the average value of the diameters is determined. Furthermore, in the electron microscopic photograph of a cross-section, in a case in which the two-dimensional shape is an approximately circular shape, the diameter of the circle is measured; in a case in which the two-dimensional shape is an approximately elliptical shape, the minor axis of the ellipse is measured; in a case in which the two-dimensional shape is an approximately square shape, the length of an edge of the square is measured; and in a case in which the two-dimensional shape is an approximately rectangular shape, the length of a shorter edge of the rectangle is measured.

### (2) Method for measuring average pore diameter

The "average pore diameter" is obtained by observing the cross-sectional shapes of ten to twenty pore diameters randomly selected using scanning electron microscopy (SEM), measuring the diameters, and calculating the average value of the diameters.

### (3) Method for measuring porosity

Measurement of the porosity can be determined by taking electron microscopic photographs by transmission electron microscopy (TEM), and performing an analysis of the cross-sectional images. Furthermore, the porosity in the case in which the pore size is smaller than 100 nm is measured by slicing a sample by an ultramicrotome method and observing the slices by transmission electron microscopy (TEM).

Subsequently, as illustrated in Fig. 6, a wire bonding process of electrically connecting the tip of a terminal (not illustrated in the diagram) of the substrate 40 and an electrode pad (not illustrated in the diagram) on the semiconductor element 2 by means of a bonding wire 60 is performed. As the bonding wire 60, for example, a gold wire, an aluminum wire, or a copper wire is used. The temperature at the time of performing wire bonding is preferably 80°C or higher, and more preferably 120°C or higher, and the temperature is preferably 250°C or lower, and more preferably 175°C or lower. Furthermore, the heating time is carried out for several seconds to several minutes (for example, 1 second to 1 minute). Wire connection is carried out in a heated state such that the temperature is within the above-mentioned temperature range, by using vibration energy caused by ultrasonic waves and pressure bonding energy caused by applied pressure in combination.

Subsequently, an encapsulation process of encapsulating the semiconductor element 2 using an encapsulating resin 70 is performed. The present process is carried out in order to protect the semiconductor element 2 or the bonding wire 60 mounted on the substrate 40. The present process is carried out by molding a resin for encapsulation in a mold. As the encapsulating resin 70, for example, an epoxy-based resin is used. The heating temperature at the time of resin encapsulation is preferably 165°C or higher, and more preferably 170°C or higher, and the heating temperature is preferably 185°C or lower, and more preferably 180°C or lower.

If necessary, the encapsulation product may be further heated (post-curing process). Thereby, the encapsulating resin 70 that is under-cured in the encapsulation process can be completely cured. The heating temperature can be set as appropriate. Thereby, a semiconductor device 100 is produced.

In the above-described example, the joining film was used in the case of joining the back surface of a semiconductor element 2, on which a circuit is not formed, and a substrate 40; however, the example is not limited to this, and the joining film may also be used in the case of joining the front surface of a semiconductor element 2, on which a circuit is formed, and a substrate 40 (so-called flip-chip mounting).

### EXAMPLES

Next, Examples of the present invention will be described; however, the present invention is not intended to be limited to these Examples.

### (i) Production of copper fine particles and copper microparticle paste

70% by mass of copper fine particles having an average primary particle size of 150 nm, which had been produced by electroless reduction from copper ions in an aqueous solution, and 30% by mass of an organic dispersing medium composed of 95% by mass of a mixed solvent (corresponding to the organic solvent (S1)) including 40% by volume of glycerol, 55% by volume of N-methylacetamide, and 5% by volume of triethylamine as an organic solvent, and 5% by mass of ethyl cellulose (average molecular weight 1,000,000) as an organic binder, were kneaded, and thus an electroconductive paste was produced.

### (ii) Production of silver fine particles and silver microparticle paste

70% by mass of silver fine particles (manufactured by Sigma-Aldrich Japan K.K., product No.: 730777) having an average primary particle size of 100 nm and 30% by mass of an organic dispersing medium composed of 95% by mass of a mixed solvent (corresponding to the organic solvent (S1)) including 40% by volume of glycerol, 55% by volume of N-methylacetamide, and 5% by volume of triethylamine as an organic solvent, and 5% by mass of ethyl cellulose (average molecular weight 1,000,000) as an organic binder, were kneaded, and thus an electroconductive paste was produced.

On a mounting stand, a release film (50-µm polyethylene terephthalate film) was disposed, and a spacer made of SUS and having a 6-inch circular opening at the center with a thickness of 350 µm was disposed thereon. 5.0 g of the above-mentioned electroconductive paste was placed on the release film that was in contact with the opening of the spacer. Screen printing was performed using a squeegee so as to roll the electroconductive paste, and the electroconductive paste was molded into a circular sheet shape. The spacer was removed, and then preliminary drying was performed for 15 minutes at 110°C in an inert atmosphere. Thus, an electroconductive joining layer was produced.

Furthermore, 10% by mass of polyglycerin and 90% by mass of methanol were mixed, polyglycerin was diluted, and a tack layer composition was produced.

Then, on a hot plate that had been warmed to 50°C, the above-mentioned tack layer composition was applied on the electroconductive joining layer by a spray coating method such that the film thickness after drying would be 2 µm. The tack layer composition was dried at 50°C for 180 seconds, and thus a tack layer was formed. In this manner, a joining film was obtained.

On the other hand, a self-adhesive film was produced as follows. To an acrylic copolymer having a weight average molecular weight of 800,000, which had been synthesized by radical polymerizing 65 parts by weight of butyl acrylate, 25 parts by weight of 2-hydroxyethyl acrylate, and 10 parts by weight of acrylic acid, and adding dropwise 2-isocyanate ethyl methacrylate thereto to react with the polymerization product, 3 parts by weight of polyisocyanate as a curing agent, and 1 part by weight of 1-hydroxycyclohexyl phenyl ketone as a photopolymerization initiator were added and mixed. Thus, a self-adhesive layer composition was obtained. The self-adhesive layer composition thus produced was applied on a film (a film for coating other than the base material film) such that the dried film thickness would be 10 µm, and the composition was dried for 3 minutes at 120°C. Subsequently, the self-adhesive layer composition that had been applied on the film was transferred onto a polypropylene elastomer (elastomer of PP : HSBR = 80 : 20) resin film having a thickness of 100 µm as a base material film. Thus, a self-adhesive film was produced.

Meanwhile, as the polypropylene (PP), NOVATEC FG4 manufactured by Japan Polychem Corporation was used, and as the hydrogenated styrene-butadiene (HSBR), DYNARON 1320P manufactured by JSR Corporation was used. Furthermore, as the film for coating, a silicone release-treated PET film (Teijin: HUPIREX S-314, thickness 25 µm) was used.

Subsequently, the electroconductive joining layer of the joining film was stuck onto the self-adhesive layer of the self-adhesive film, and thus a tape for wafer processing according to the Example was obtained.

As a semiconductor wafer, a semiconductor wafer having a thickness of 230 µm and having a chip electrode layer of Ti/Au = 100 nm/200 nm formed on the surface was prepared, and as a substrate, an oxygen-free copper plate having a thickness of 1.2 mm and a semi-hard temper was prepared. The tape for wafer processing according to the Example described above was placed and heated on a hot plate that had been heated to 80°C, and in a state of having increased the adhesiveness of the tack layer to the front surface of the semiconductor wafer (surface on the chip electrode layer side), the front surface of the semiconductor wafer was attached to the tack layer. Subsequently, the assembly was returned to room temperature, and in a state of having the tack layer cooled and cured, the semiconductor wafer was diced into semiconductor chips each having a size of 7 mm × 7 mm together with the joining film using a dicing apparatus (manufactured by Disco Corporation, DAD340 (trade name)). Subsequently, the semiconductor chips were irradiated with ultraviolet radiation through the base material film surface side of the self-adhesive film using an ultraviolet irradiator of a high-pressure mercury lamp such that the amount of irradiation was 200 mJ/cm². The self-adhesive film was expanded using a die bonder (manufactured by Canon Machinery, Inc., CPS-6820 (trade name)), and in that state, the semiconductor chips were picked up together with the joining film and placed on the substrate such that the electroconductive joining layer side of the joining film faced the substrate.

Subsequently, laminates of the semiconductor chip, the joining film, and the substrate were heated such that a laminate formed using the copper microparticle paste was heated for 60 minutes at 300°C, and a laminate formed using the silver microparticle paste was heated for 60 minutes at 250°C. Thereby, the electroconductive joining layer was sintered, and twenty mounted samples were produced.

The mounted samples were subjected to a thermal shock test of maintaining at -55°C for 30 minutes and at 200°C for 30 minutes as one cycle. After every 100 times, the samples were taken out and examined by visual inspection to see whether cracking or peeling had occurred. Subsequently, the samples were irradiated with ultrasonic waves through the semiconductor chip side using an ultrasonic microscope (manufactured by Hitachi Construction Machinery Co., Ltd., MI-SCOPE (trade name))) and a probe (type "PQ2-13", 50 MHz), and measurement of peeling was carried out by a reflection method. A sample having a peeled area of more than 10% was considered as failure. Regarding the mounted samples that used the joining film of the tape for wafer processing according to the present Example, in all of the samples formed from copper fine particles and the samples formed from silver fine particles, the number of times of TCT carried out until the sample was considered as failure was 1,000 times or more, and results with high reliability were obtained.

Furthermore, as the tape for wafer processing according to the present Example was used, the semiconductor wafer and the joining film could be diced simultaneously, and since the semiconductor chips after dicing could be picked up together with the joining film and placed on a substrate, the mounting process could be carried out simply and easily.

### EXPLANATIONS OF LETTERS OR NUMERALS

- 2: SEMICONDUCTOR ELEMENT
- 10: TAPE FOR WAFER PROCESSING
- 11: RELEASE FILM
- 12: SELF-ADHESIVE FILM
- 12a: BASE MATERIAL FILM
- 12b: SELF-ADHESIVE LAYER
- 13: JOINING FILM
- 13a: ELECTROCONDUCTIVE JOINING LAYER
- 13b: TACK LAYER
- 40: SUBSTRATE

## Claims

1. A joining film for joining a semiconductor element and a substrate,
the joining film comprising:
an electroconductive joining layer formed by molding an electroconductive paste containing metal fine particles (P) into a film form, wherein the metal fine particles (P) have an average primary particle size before a heating treatment of 10 to 500 nm and wherein the average particle size is determined by a method for measuring average particle size of metal fine particles as defined in the description; and
a tack layer having tackiness and being laminated with the electroconductive joining layer,
wherein the tack layer is formed from one kind or two kinds selected from polyglycerin and a polyglycerin fatty acid ester.

2. The joining film according to claim 1,
wherein the tack layer is thermally decomposed by heating at the time of joining, the metal fine particles (P) of the electroconductive joining layer are sintered, and thereby the semiconductor element and the substrate are joinable.

3. The joining film according to claim 1 or 2, wherein the metal fine particles (P) have an average primary particle size of 10 to 500 nm, and the electroconductive paste includes an organic solvent (S).

4. The joining film according to any one of claims 1 to 3, wherein the metal fine particles (P) are formed from copper or silver.

5. The joining film according to any one of claims 1 to 4, wherein the electroconductive paste includes an organic binder (R).

6. The joining film according to any one of claims 3 to 5, wherein the organic solvent (S) includes an organic solvent (SC) formed from an alcohol and/or a polyhydric alcohol, each having a boiling point at normal pressure of 100°C or higher and having one or two or more hydroxyl groups in the molecule.

7. The joining film according to any one of claims 4 to 6, wherein the organic binder (R) is one kind or two or more kinds selected from a cellulose resin-based binder, an acetate resin-based binder, an acrylic resin-based binder, a urethane resin-based binder, a polyvinylpyrrolidone resin-based binder, a polyamide resin-based binder, a butyral resin-based binder, and a terpene-based binder.

8. A tape for wafer processing, comprising:
a self-adhesive film having a base material film and a self-adhesive layer provided on the base material film; and
the joining film according to any one of claims 1 to 7, wherein the electroconductive joining layer of the joining film is provided on the self-adhesive layer.

9. A method for producing a joined body, the method comprising a joining step of joining a semiconductor element and a substrate by disposing a joining film according to any of claims 1 to 7 between the semiconductor element and the substrate, the joining film having an electroconductive joining layer formed by molding an electroconductive paste containing metal fine particles (P) into a film form, and a tack layer having tackiness and being laminated with the electroconductive joining layer; heating the joining film; and thermally decomposing the tack layer so as to sinter the metal fine particles (P) of the electroconductive joining layer.

## Patentansprüche

1. Fügefilm zum Zusammenfügen eines Halbleiterelements und eines Substrats, umfassend:
eine elektrisch leitfähige Fügeschicht, die durch Formen einer metallische Feinpartikel (P) enthaltenden elektrisch leitfähigen Paste zu einem Film ausgebildet ist,
wobei die metallischen Feinpartikel (P) vor einer Wärmebehandlung eine mittlere Primärpartikelgröße von 10 bis 500 nm aufweisen und wobei die mittlere Partikelgröße nach einem in der Beschreibung definierten Verfahren zum Messen einer mittleren Partikelgröße metallischer Feinpartikel bestimmbar ist; und
eine Haftschicht, die Haftfähigkeit aufweist und mit der elektrisch leitfähigen Fügeschicht laminiert ist,
wobei die Haftschicht aus Polyglycerin und/oder einem Polyglycerin-Fettsäureester ausgebildet ist.

2. Fügefilm nach Anspruch 1,
wobei das Halbleiterelement und das Substrat durch thermisches Zersetzen der Haftschicht mittels Erhitzung zum Zeitpunkt des Zusammenfügens und Sintern der metallischen Feinpartikel (P) der elektrisch leitfähigen Fügeschicht zusammenfügbar sind.

3. Fügefilm nach Anspruch 1 oder 2, wobei die metallischen Feinpartikel (P) eine mittlere Primärpartikelgröße von 10 bis 500 nm aufweisen und die elektrisch leitfähige Paste ein organisches Lösungsmittel (S) enthält.

4. Fügefilm nach einem der Ansprüche 1 bis 3, wobei die metallischen Feinpartikel (P) aus Kupfer oder Silber ausgebildet sind.

5. Fügefilm nach einem der Ansprüche 1 bis 4, wobei die elektrisch leitfähige Paste ein organisches Bindemittel (R) enthält.

6. Fügefilm nach einem der Ansprüche 3 bis 5, wobei das organische Lösungsmittel (S) ein organisches Lösungsmittel (SC) umfasst, das aus einem Alkohol und/oder einem mehrwertigen Alkohol ausgebildet ist, die jeweils einen Siedepunkt von 100 °C oder höher bei Normaldruck aufweisen und zwei oder mehr Hydroxylgruppen im Molekül aufweisen.

7. Fügefilm nach einem der Ansprüche 4 bis 6, wobei es sich bei dem organischen Bindemittel (R) um ein, zwei oder mehrere aus Celluloseharz-Bindemittel, Acetatharz-Bindemittel, Acrylharz-Bindemittel, Urethanharz-Bindemittel, Polyvinylpyrrolidonharz-Bindemittel, Polyamidharz-Bindemittel, Butyralharz-Bindemittel und Terpen-Bindemittel ausgewählte(s) Bindemittel handelt.

8. Band zur Wafer-Verarbeitung, umfassend:
einen selbstklebenden Film mit einem Basismaterialfilm und einer auf dem Basismaterialfilm vorgesehenen selbstklebenden Schicht; und
den Fügefilm nach einem der Ansprüche 1 bis 7,
wobei die elektrisch leitfähige Fügeschicht des Fügefilms auf der selbstklebenden Schicht vorgesehen ist.

9. Verfahren zur Herstellung eines zusammengefügten Körpers, umfassend: Zusammenfügen eines Halbleiterelements und eines Substrats durch Anordnen eines Fügefilms nach einem der Ansprüche 1 bis 7 zwischen dem Halbleiterelement und dem Substrat, wobei der Fügefilm eine elektrisch leitfähige Fügeschicht, die durch Formen einer metallische Feinpartikel (P) enthaltenden elektrisch leitfähigen Paste zu einem Film herstellt ist, und eine Haftschicht, die Haftfähigkeit aufweist und mit der elektrisch leitfähigen Fügeschicht laminiert ist, aufweist; Erhitzen des Fügefilms; und thermisches Zersetzen der Haftschicht zum Sintern der metallischen Feinpartikel (P) der elektrisch leitfähigen Fügeschicht.

## Revendications

1. Film de liaison pour assembler un élément semi-conducteur et un substrat,
le film de liaison comprenant :
une couche de liaison électroconductrice formée en moulant une pâte électroconductrice contenant des particules fines métalliques (P) en forme de film, dans lequel les particules fines métalliques (P) ont une taille moyenne de particules primaires de 10 à 500 nm avant un traitement thermique et dans lequel la taille moyenne de particules est déterminée par un procédé de mesure de la taille moyenne de particules fines métalliques tel que défini dans la description ; et
une couche adhésive ayant de l'adhérence et étant laminée avec la couche de liaison électroconductrice,
dans laquelle la couche adhésive est formée à partir d'un ou deux types choisis parmi la polyglycérine et un ester d'acide gras de polyglycérine.

2. Film de liaison selon la revendication 1,
dans lequel la couche adhésive est décomposée thermiquement par chauffage au moment de l'assemblage, les particules fines métalliques (P) de la couche de liaison électroconductrice sont frittées, et ainsi l'élément semi-conducteur et le substrat peuvent être assemblés.

3. Film de liaison selon la revendication 1 ou 2, dans lequel les particules fines métalliques (P) ont une taille moyenne de particules primaires de 10 à 500 nm et la pâte électroconductrice comprend un solvant organique (S).

4. Film de liaison selon l'une quelconque des revendications 1 à 3, dans lequel les particules fines métalliques (P) sont formées à partir de cuivre ou d'argent.

5. Film de liaison selon l'une quelconque des revendications 1 à 4, dans lequel la pâte électroconductrice comprend un liant organique (R).

6. Film de liaison selon l'une quelconque des revendications 3 à 5, dans lequel le solvant organique (S) comprend un solvant organique (SC) formé à partir d'un alcool et/ou d'un alcool polyhydrique, chacun ayant un point d'ébullition à pression normale de 100 °C ou plus et comportant un ou deux ou plusieurs groupes hydroxyle dans la molécule.

7. Film de liaison selon l'une quelconque des revendications 4 à 6, dans lequel le liant organique (R) est un type ou deux types ou plus choisis parmi un liant à base de résine de cellulose, un liant à base de résine d'acétate, un liant à base de résine acrylique, un liant à base de résine d'uréthane, un liant à base de résine de polyvinylpyrrolidone, un liant à base de résine de polyamide, un liant à base de résine butyral et un liant à base de terpène.

8. Ruban pour le traitement de wafers, comprenant :
un film auto-adhésif ayant un film de matériau de base et une couche auto-adhésive prévue sur le film de matériau de base ; et
le film de liaison selon l'une quelconque des revendications 1 à 7,
dans lequel la couche de liaison électroconductrice du film de liaison est prévue sur la couche auto-adhésive.

9. Procédé de fabrication d'un corps assemblé, le procédé comprenant une étape d'assemblage consistant à assembler un élément semi-conducteur et un substrat en disposant un film de liaison selon l'une quelconque des revendications 1 à 7 entre l'élément semi-conducteur et le substrat, le film de liaison ayant une couche de liaison électroconductrice formée en moulant une pâte électroconductrice contenant des particules fines métalliques (P) en forme de film, et une couche adhésive ayant de l'adhérence et étant laminée avec la couche de liaison électroconductrice ; chauffer le film de liaison ; et décomposer thermiquement la couche adhésive de manière à fritter les particules fines métalliques (P) de la couche de liaison électroconductrice.
